# EUROPÄISCHE PATENTANMELDUNG

(11) **EP 4 311 620 A1**
(43) Veröffentlichungstag der Anmeldung: **31.01.2024**
(21) Anmeldenummer: 22187679.0
(22) Anmeldetag: 29.07.2022
(51) Int. Cl.: B23K 20/12, H01L 21/48, H01L 23/427, H01L 23/473, H05K 7/20

(54) **HERSTELLEN EINES KÜHLKÖRPERS**

(71) Anmelder: Siemens Aktiengesellschaft, 80333 München (DE)
(72) Erfinder: Müller, Volker, 90459 Nürnberg (DE); Danov, Vladimir, 91056 Erlangen (DE); Kneißl, Philipp, 90427 Nürnberg (DE); Neugebauer, Stephan, 91058 Erlangen (DE); Schwarz, Florian, 90766 Fürth (DE)
(74) Vertreter: Siemens Patent Attorneys

(57) **Zusammenfassung**

Die Erfindung betrifft ein Verfahren zum Herstellen eines Kühlkörpers (1). Bei dem Verfahren wird zunächst ein Grundkörper (3) mit wenigstens einem Hauptkühlkanal (5,7), der von einer ersten Außenoberfläche (9) des Grundkörpers (3) zu einer der ersten Außenoberfläche (9) gegenüberliegenden zweiten Außenoberfläche (11) des Grundkörpers (3) verläuft, hergestellt. Anschließend wird in dem Grundkörper (3) durch Friction Stir Channeling wenigstens ein Nebenkühlkanal (17,19) erzeugt, der mit wenigstens einem Hauptkühlkanal (5,7) verbunden ist, und wenigstens ein Hauptkühlkanal (5,7) wird an wenigstens einer Außenoberfläche (9,11) des Grundkörpers (3) verschlossen.

## Beschreibung

Die Erfindung betrifft ein Verfahren zum Herstellen eines Kühlkörpers.

Kühlkörper werden unter anderem zum Kühlen elektronischer Baugruppen eingesetzt. Bei derartigen Baugruppen entsteht im Betrieb Wärme, die abgeführt werden muss, um eine Überhitzung der jeweiligen Baugruppe zu verhindern. Derartige Kühlkörper weisen häufig eine interne Kanalstruktur mit Kühlkanälen auf, die von einer Kühlflüssigkeit durchströmt wird, um Wärme abzuführen. Die Herstellung eines derartigen Kühlkörpers ist kostenintensiv und erfordert in der Regel mehrere unterschiedliche Fertigungsschritte.

Beispielsweise wird zum Herstellen eines Kühlkörpers zunächst in einen Grundkörper des Kühlkörpers die Kanalstruktur gefräst und anschließend wird der Grundkörper mit einem Deckel verschlossen, der dann mittels Vakuumhartlöten mit dem Grundkörper dicht und mechanisch stabil verbunden wird. Alternativ wird beispielsweise zunächst die Kanalstruktur gefräst und anschließend werden in die Kanalstruktur Kühlrohre eingesetzt.

Bei einem weiteren Verfahren zum Herstellen eines Kühlkörpers wird beispielsweise zunächst ein Grundkörper mit zueinander parallelen Kühlkanälen mittels eines Strangpressverfahrens erzeugt. Anschließend werden diese parallelen Kühlkanäle mittels quer dazu verlaufenden Löchern verbunden. Die Löcher werden häufig mit aufwändigen Technologien zum genauen Bohren der Löcher mit einem sehr großen Verhältnis von Lochlänge zu Lochdurchmesser erzeugt. Nachträglich werden die parallelen Kühlkanäle und die Löcher mittels Stopfen nach außen verschlossen. Die Stopfen werden dabei beispielsweise eingeschraubt und die Gewinde werden zusätzlich mit Gewindekleber abgedichtet.

Der Erfindung liegt die Aufgabe zugrunde, ein verbessertes, insbesondere vereinfachtes, Verfahren zum Herstellen eines Kühlkörpers mit einer Kühlkanalstruktur anzugeben.

Die Aufgabe wird erfindungsgemäß durch ein Verfahren mit den Merkmalen des Anspruchs 1, einen Kühlkörper mit den Merkmalen des Anspruchs 13 und eine elektronische Baugruppe mit den Merkmalen des Anspruchs 14 gelöst.

Vorteilhafte Ausgestaltungen der Erfindung sind Gegenstand der Unteransprüche.

Bei dem erfindungsgemäßen Verfahren zum Herstellen eines Kühlkörpers wird zunächst ein Grundkörper mit wenigstens einem Hauptkühlkanal, der von einer ersten Außenoberfläche des Grundkörpers zu einer der ersten Außenoberfläche gegenüberliegenden zweiten Außenoberfläche des Grundkörpers verläuft, hergestellt. Insbesondere kann ein Grundkörper mit mehreren zueinander parallelen Hauptkühlkanälen hergestellt werden, die jeweils von der ersten Außenoberfläche zu der zweiten Außenoberfläche des Grundkörpers verlaufen. In dem Grundkörper wird anschließend durch Friction Stir Channeling wenigstens ein Nebenkühlkanal erzeugt, der mit wenigstens einem Hauptkühlkanal verbunden ist, und wenigstens ein Hauptkühlkanal wird an wenigstens einer Außenoberfläche des Grundkörpers verschlossen.

Das erfindungsgemäße Verfahren sieht also vor, die Kühlkanalstruktur eines Kühlkörpers zu einem Teil durch so genanntes Friction Stir Channeling zu erzeugen. Darunter wird eine Abwandlung des bekannteren so genannten Friction Stir Welding verstanden, das auf Deutsch auch als Rührreibschweißen oder Reibrührschweißen bezeichnet wird. Beim Friction Stir Welding wird ein Spalt verschweißt oder verschlossen, indem ein rotierendes Werkzeug in den Spalt gedrückt wird. Durch die Rotation erwärmt sich der Werkstoff in der Umgebung des Werkzeugs und weicht auf, ohne jedoch zu schmelzen. Das Werkzeug wird dann entlang des Spaltes bewegt, wodurch sich der Spalt mit dem aufgeweichten Werkstoff schließt. Beim Friction Stir Channeling wird das rotierende Werkzeug derart gestaltet und bewegt, dass in einem Werkstück ein Kanal beziehungsweise eine Kavität entsteht. Friction Stir Channeling könnte man daher auch als Rührreibkanalisieren oder Reibrührkanalisieren bezeichnen. Beim Friction Stir Channeling kann ein in dem Werkstück erzeugter Kanal beziehungsweise eine in dem Werkstück erzeugte Kavität gegebenenfalls auch gleich verschlossen werden, so dass im Inneren des Werkstücks ein Kanal entsteht, der nach außen verschlossen ist. Friction Stir Channeling ermöglicht damit eine einfache und kostengünstige Erzeugung von Kühlkanälen in einem Kühlkörper, die insbesondere keine kostenintensiven spanenden oder vakuumlötenden Prozesse erfordert.

Bei einer Ausgestaltung des erfindungsgemäßen Verfahrens wird wenigstens ein Hauptkühlkanal an wenigstens einer Außenoberfläche des Grundkörpers durch Friction Stir Welding verschlossen. Hierfür kann gegebenenfalls mindestens ein weiteres Verschlussteil eingesetzt werden, das mittels Friction Stir Welding mit dem Grundkörper verbunden wird. Diese Ausgestaltung der Erfindung nutzt somit Friction Stir Welding zum Verschließen von Hauptkühlkanälen und kombiniert somit vorteilhaft Friction Stir Channeling und Friction Stir Welding bei der Herstellung der Kühlkanalstruktur.

Bei einer weiteren Ausgestaltung des erfindungsgemäßen Verfahrens wird der Grundkörper durch Strangpressen oder Extrusion erzeugt. Dies reduziert die Kosten der Herstellung des Kühlkörpers weiter, indem der Grundkörper mit Hauptkühlkanälen besonders kostengünstig durch Strangpressen oder Extrusion hergestellt wird.

Bei einer weiteren Ausgestaltung des erfindungsgemäßen Verfahrens wird der Grundkörper aus einem metallischen Werkstoff hergestellt. Beispielsweise weist der metallische Werkstoff eine hohe Duktilität und eine Kristallstruktur mit einem kubisch-flächenzentrierten Kristallgitter auf. Insbesondere kann der metallische Werkstoff Aluminium oder Kupfer sein.

Alternativ wird der Grundkörper beispielsweise aus einem thermoplastischen Kunststoff hergestellt, beispielsweise aus Acrylnitril-Butadien-Styrol (ABS), einem Polyamid (PA), Polylactat (PLA), Polymethylmethacrylat (PMMA), Polycarbonat (PC), Polyethylenterephthalat (PET), Polyethylen (PE), Polypropylen (PP), Polystyrol (PS), Polyetheretherketon (PEEK) oder Polyvinylchlorid (PVC).

Die vorgenannten Werkstoffe eignen sich insbesondere zum Friction Stir Channeling und daher für die Herstellung eines Kühlkörpers nach dem erfindungsgemäßen Verfahren.

Bei einer weiteren Ausgestaltung des erfindungsgemäßen Verfahrens weisen wenigstens zwei Hauptkühlkanäle voneinander verschiedene Querschnitte auf und/oder wenigstens zwei Nebenkühlkanäle weisen voneinander verschiedene Querschnitte auf. Durch die Wahl geeigneter, aufeinander abgestimmter Querschnitte der Kühlkanäle kann vorteilhaft die Kühlwirkung der Kanalstruktur optimiert werden.

Bei einer weiteren Ausgestaltung des erfindungsgemäßen Verfahrens bildet wenigstens ein Teil der Hauptkühlkanäle und Nebenkühlkanäle Kanäle einer pulsierenden Heatpipe. Eine pulsierende Heatpipe (engl. Pulsating Heat Pipe, abgekürzt: PHP), die auch als oszillierende Heatpipe (engl. Oscillating Heat Pipe) bezeichnet wird, weist einen in der Regel vielfach gebogenen dünnen Kanal auf, der partiell mit einer Flüssigkeit gefüllt ist. Da die Flüssigkeit das Volumen des Kanals nicht vollständig ausfüllt, bilden sich in dem Kanal durch die Oberflächenspannung der Flüssigkeit an der Wand des Kanals von der Flüssigkeit ausgefüllte Flüssigkeitsbereiche, die voneinander durch von Dampf gebildeten Dampfbereichen getrennt sind. Durch Temperaturunterschiede in verschiedenen Abschnitten der Heatpipe pulsieren beziehungsweise oszillieren die Flüssigkeitsbereiche und ermöglichen einen Wärmetransport und Temperaturausgleich zwischen diesen Abschnitten. Das erfindungsgemäße Verfahren eignet sich insbesondere auch zur Herstellung eines Kühlkörpers mit einer pulsierenden Heatpipe.

Ein erfindungsgemäßer Kühlkörper ist mit dem erfindungsgemäßen Verfahren hergestellt.

Eine erfindungsgemäße elektronische Baugruppe weist einen erfindungsgemäßen Kühlkörper auf.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein Ablaufdiagramm eines Ausführungsbeispiels des erfindungsgemäßen Verfahrens,
- FIG 2: eine Schnittdarstellung eines Ausführungsbeispiels eines Kühlkörpers,
- FIG 3: eine Seitenansicht eines Ausführungsbeispiels einer elektronischen Baugruppe,
- FIG 4: eine Schnittdarstellung der in FIG 3 gezeigten elektronischen Baugruppe.

Einander entsprechende Teile sind in den Figuren mit denselben Bezugszeichen versehen.

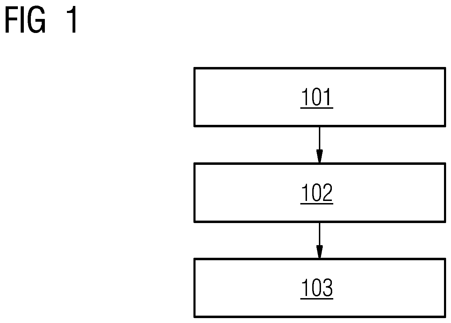

FIG 1 zeigt ein Ablaufdiagramm eines Ausführungsbeispiels des erfindungsgemäßen Verfahrens mit Verfahrensschritten 101, 102, 103 zum Herstellen eines Kühlkörpers 1.

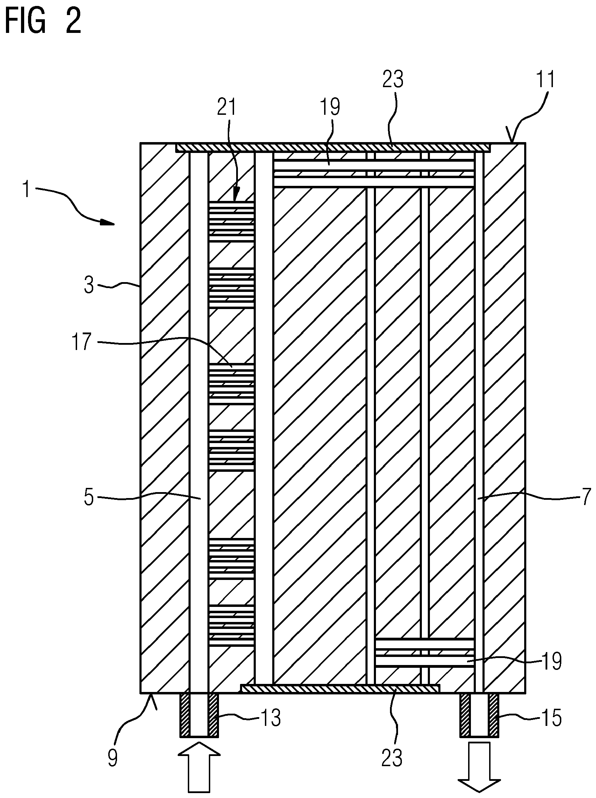

Die Verfahrensschritte 101, 102, 103 werden nachfolgend auch Bezug nehmend auf FIG 2 beschrieben.

FIG 2 zeigt ein Ausführungsbeispiel eines mit dem erfindungsgemäßen Verfahren hergestellten Kühlkörpers 1.

In einem ersten Verfahrensschritt 101 wird ein Grundkörper 3 mit zueinander parallelen Hauptkühlkanälen 5, 7 hergestellt, die jeweils von einer ersten Außenoberfläche 9 des Grundkörpers 3 zu einer der ersten Außenoberfläche 9 gegenüberliegenden zweiten Außenoberfläche 11 des Grundkörpers 3 verlaufen. In dem in FIG 2 gezeigten Ausführungsbeispiel weist der Grundkörper 3 fünf Hauptkühlkanäle 5, 7 auf, von denen zwei erste Hauptkühlkanäle 5 gleiche Querschnitte aufweisen und drei zweite Hauptkühlkanäle 7 ebenfalls gleiche Querschnitte aufweisen, die jedoch kleiner als die Querschnitte der ersten Hauptkühlkanäle 5 sind. Ein erster Hauptkühlkanal 5 ist mit einem Einlass 13 des Kühlkörpers 1 zum Einlassen eines Kühlfuids verbunden. Ein zweiter Hauptkühlkanal 7 ist mit einem Auslass 15 des Kühlkörpers 1 zum Auslassen des Kühlfluids verbunden.

Der Grundkörper 3 wird beispielsweise durch Strangpressen oder Extrusion erzeugt.

Beispielsweise wird der Grundkörper 3 aus einem metallischen Werkstoff hergestellt. Der metallische Werkstoff weist beispielsweise eine Kristallstruktur mit einem kubisch-flächenzentrierten Kristallgitter auf. Beispielsweise ist der metallische Werkstoff Aluminium oder Kupfer.

Alternativ wird der Grundkörper 3 aus einem thermoplastischen Kunststoff hergestellt, beispielsweise aus Acrylnitril-Butadien-Styrol, einem Polyamid, Polylactat, Polymethylmethacrylat, Polycarbonat, Polyethylenterephthalat, Polyethylen, Polypropylen, Polystyrol, Polyetheretherketon oder Polyvinylchlorid.

In einem zweiten Verfahrensschritt 102 werden durch Friction Stir Channeling Nebenkühlkanäle 17, 19 erzeugt, die jeweils wenigstens zwei Hauptkühlkanäle 5, 7 verbinden. In dem in FIG 2 gezeigten Ausführungsbeispiel verlaufen die Nebenkühlkanäle 17, 19 senkrecht zu den Hauptkühlkanälen 5, 7. Dabei verbinden gleichartige erste Nebenkühlkanäle 17 jeweils die beiden ersten Hauptkühlkanäle 5 miteinander. Die ersten Nebenkühlkanäle 17 bilden mehrere voneinander beabstandet angeordnete Nebenkühlkanalgruppen 21, die jeweils eine Mehrzahl von ersten Nebenkühlkanälen 17 aufweisen. Zweite Nebenkühlkanäle 19 verbinden jeweils einen ersten Hauptkühlkanal 5 mit wenigstens einem zweiten Hauptkühlkanal 7 oder wenigstens zwei zweite Hauptkühlkanäle 7. Die ersten Nebenkühlkanäle 17 weisen kleinere Querschnitte als die zweiten Nebenkühlkanäle 19 auf. Vorzugsweise werden die durch das Friction Stir Channeling erzeugten Nebenkühlkanäle 17, 19 auch durch das Friction Stir Channeling verschlossen, so dass durch das Friction Stir Channeling keine Öffnungen an einer Außenseite des Grundkörpers 3 entstehen.

In einem dritten Verfahrensschritt 103 werden die Hauptkühlkanäle 5, 7 an den Außenoberflächen 9, 11 verschlossen, mit Ausnahme an dem Einlass 13 und dem Auslass 15. Beispielsweise werden die Hauptkühlkanäle 5, 7 durch Friction Stir Welding verschlossen. In FIG 2 sind dabei entstehende Schweißnähte 23 dargestellt. Sollten in dem zweiten Verfahrensschritt 102 durch das Friction Stir Channeling Öffnungen an einer Außenseite des Grundkörpers 3 entstanden sein, die nicht durch das Friction Stir Channeling bereits verschlossen wurden, werden diese Öffnungen in dem dritten Verfahrensschritt 103 ebenfalls verschlossen, beispielsweise ebenfalls durch Friction Stir Welding.

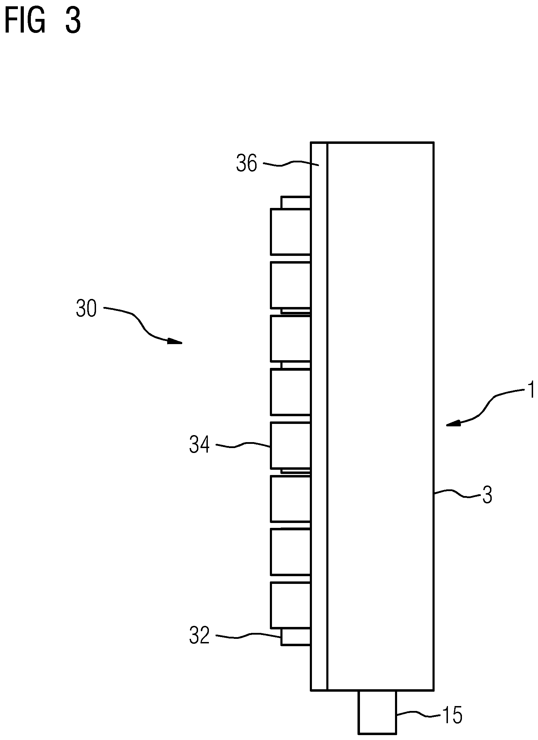

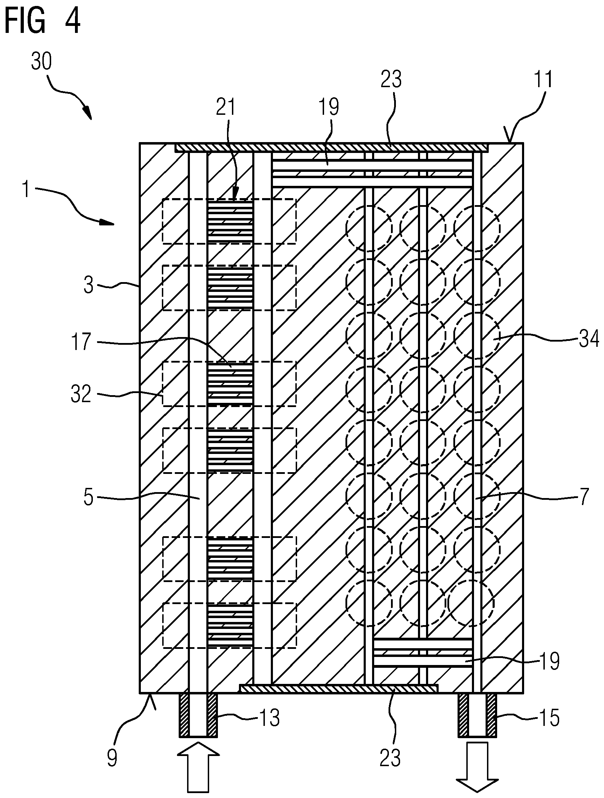

FIG 3 und FIG 4 zeigen ein Ausführungsbeispiel einer elektronischen Baugruppe 30 mit einem Kühlkörper 1, der wie der in FIG 2 gezeigte Kühlkörper 1 ausgebildet und hergestellt ist. FIG 3 zeigt eine Seitenansicht der elektronischen Baugruppe 30. Die elektronische Baugruppe 30 weist mehrere elektronische Bauelemente 32, 34 auf. Beispielsweise sind erste elektronische Bauelemente 32 Halbleiterschalter wie IGBTs (IGBT: Abkürzung für Insulated-Gate Bipolar Transistor, deutsch: Bipolartransistor mit isolierter Gate-Elektrode) und zweite elektronische Bauelemente 34 sind Kondensatoren. Die elektronischen Bauelemente 32, 34 sind auf einer Bodenplatte 36 angeordnet, die an dem Kühlkörper 1 anliegt. FIG 4 zeigt eine Schnittdarstellung der elektronischen Baugruppe 30, wobei die Schnittebene wie in FIG 2 durch den Kühlkörper 1 verläuft. Dabei deutet FIG 4 gestrichelt die Lage der elektronische Bauelemente 32, 34 relativ zu den Hauptkühlkanälen 5, 7 und Nebenkühlkanälen 17, 19 an. Die Nebenkühlkanalgruppen 21 sind in Bereichen angeordnet, die jeweils zu der Lage eines ersten elektronischen Bauelements 32 korrespondieren. Die zweiten Hauptkühlkanäle 7 verlaufen in Bereichen, die zu der Lage der zweiten elektronischen Bauelemente 34 korrespondieren.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Herstellen eines Kühlkörpers (1), wobei
- ein Grundkörper (3) mit wenigstens einem Hauptkühlkanal (5,7), der von einer ersten Außenoberfläche (9) des Grundkörpers (3) zu einer der ersten Außenoberfläche (9) gegenüberliegenden zweiten Außenoberfläche (11) des Grundkörpers (3) verläuft, hergestellt wird,
- in dem Grundkörper (3) durch Friction Stir Channeling wenigstens ein Nebenkühlkanal (17,19) erzeugt wird, der mit wenigstens einem Hauptkühlkanal (5,7) verbunden ist, und
- wenigstens ein Hauptkühlkanal (5,7) an wenigstens einer Außenoberfläche (9,11) des Grundkörpers (3) verschlossen wird.

2. Verfahren nach Anspruch 1, wobei der Grundkörper (3) mit mehreren zueinander parallelen Hauptkühlkanälen (5,7) hergestellt wird, die jeweils von der ersten Außenoberfläche (9) zu der zweiten Außenoberfläche (11) des Grundkörpers (3) verlaufen.

3. Verfahren nach Anspruch 1 oder 2, wobei wenigstens ein Hauptkühlkanal (5,7) an wenigstens einer Außenoberfläche (9, 11) des Grundkörpers (3) durch Friction Stir Welding verschlossen wird.

4. Verfahren nach einem der vorhergehenden Ansprüche, wobei der Grundkörper (3) durch Strangpressen oder Extrusion erzeugt wird.

5. Verfahren nach einem der vorhergehenden Ansprüche, wobei der Grundkörper (3) aus einem metallischen Werkstoff hergestellt wird.

6. Verfahren nach Anspruch 5, wobei der metallische Werkstoff eine Kristallstruktur mit einem kubisch-flächenzentrierten Kristallgitter aufweist.

7. Verfahren nach Anspruch 5 oder 6, wobei der metallische Werkstoff Aluminium oder Kupfer ist.

8. Verfahren nach einem der Ansprüche 1 bis 4, wobei der Grundkörper (3) aus einem thermoplastischen Kunststoff hergestellt wird.

9. Verfahren nach Anspruch 8, wobei der Grundkörper (3) aus Acrylnitril-Butadien-Styrol, einem Polyamid, Polylactat, Polymethylmethacrylat, Polycarbonat, Polyethylenterephthalat, Polyethylen, Polypropylen, Polystyrol, Polyetheretherketon oder Polyvinylchlorid hergestellt wird.

10. Verfahren nach einem der vorhergehenden Ansprüche, wobei wenigstens zwei Hauptkühlkanäle (5,7) voneinander verschiedene Querschnitte aufweisen.

11. Verfahren nach einem der vorhergehenden Ansprüche, wobei wenigstens zwei Nebenkühlkanäle (17,19) voneinander verschiedene Querschnitte aufweisen.

12. Verfahren nach einem der vorhergehenden Ansprüche, wobei wenigstens ein Teil der Hauptkühlkanäle (5,7) und der Nebenkühlkanäle (17,19) Kanäle einer pulsierenden Heatpipe bildet.

13. Kühlkörper (1), der mit dem Verfahren nach einem der vorhergehenden Ansprüche hergestellt ist.

14. Elektronische Baugruppe (30) mit einem Kühlkörper (1) nach Anspruch 13.
